(19) Europäisches Patentamt

European Patent Office

Office européen des brevets

(11) **EP 1 189 238 B1**

(12) **EUROPEAN PATENT SPECIFICATION**

(45) Date of publication and mention
of the grant of the patent:
**24.05.2006 Bulletin 2006/21**

(51) Int Cl.:
*G11C 16/14* (2006.01)    *G11C 16/16* (2006.01)

(21) Application number: **01204255.2**

(22) Date of filing: **07.08.1996**

(54) **Method for erasing a flash EEPROM memory cell**

Verfahren zum Löschen einer Flash EEPROM Speicherzelle

Procédé d'effacement d'une cellule de mémoire EEPROM flash

(84) Designated Contracting States:
**BE DE FR GB**

(30) Priority: **11.08.1995 US 2197**

(43) Date of publication of application:
**20.03.2002 Bulletin 2002/12**

(62) Document number(s) of the earlier application(s) in
accordance with Art. 76 EPC:
**96870103.7 / 0 762 429**

(73) Proprietor: **INTERUNIVERSITAIR
MICROELEKTRONICA CENTRUM VZW
3001 Leuven (BE)**

(72) Inventors:
• **Van Houdt, Jan
3460 Bekkevoort (BE)**
• **Haspeslagh, Luc
8500 Kortrijk (BE)**
• **Deferm, Ludo
3851 Beverlo (BE)**
• **Groeseneken, Guido
3000 Leuven (BE)**
• **Maes, Herman
3360 Bierbeek (BE)**

(74) Representative: **Luys, Marie-José A.H. et al
Gevers & Vander Haeghen,
Intellectual Property House,
Brussels Airport Business Park
Holidaystraat 5
1831 Diegem (BE)**

(56) References cited:
**WO-A-94/15363**

**Description**

The present invention relates to a method of erasing a nonvolatile memory cell according to the preamble of claim 1.

A method of erasing a nonvolatile memory cell is for example known from WO-A-9415363.

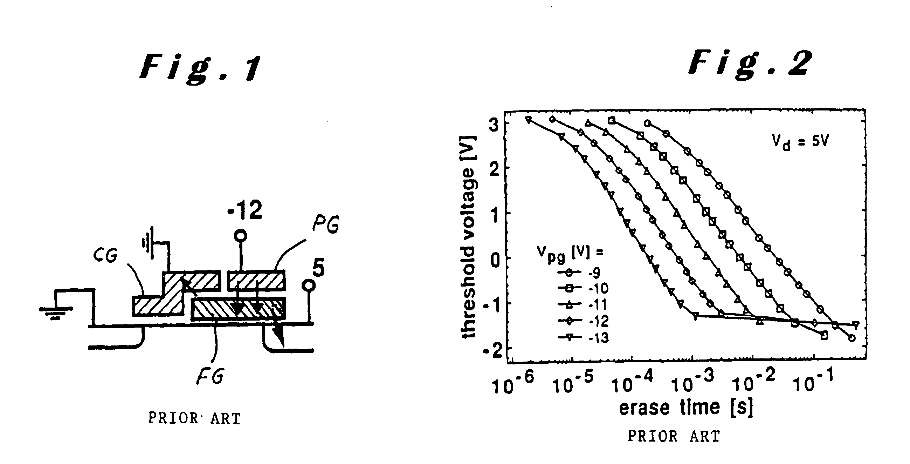

Such a method is also known and illustrated in Figure 1, showing a schematic of the previously used negative-gate-bias erase scheme where the control gate CG is grounded and the negative voltage is applied only to the program gate PG for inducing a high oxide field between the floating gate FG and the drain junction. In this case, the voltage across the tunnel oxide between the FG and the drain is approximately given by the following equation:

$$\left| V_{fg} - V_d \right| \approx p(V_t - V_{pg}) + (1 - d)V_d \qquad (1)$$

where $V_{pg}$, $V_{fg}$ and $V_d$ are the program gate voltage (PG voltage), the floating gate voltage (FG voltage) and the drain voltage during erasure, respectively, $V_t$ is the threshold voltage of the memory cell measured from the program gate (PG), and p and d are the program gate to floating gate (PG-to-FG) and the drain-to-FG capacitive coupling ratio's, respectively. Taking typical values for the parameters into account (p~=50 %, d~=10 %, $V_d$~=5V, $V_t$ varies between 2V and -4V) it can be calculated that, in order to obtain a reasonable erase time in the order of milliseconds, a program gate PG voltage of -12V is typically required for a state-of-the-art tunnel oxide of 8nm. In order to generate this high negative voltage on-chip and to switch it onto the program gate PG during the Flash erase operation, an even higher voltage in the order of-16V has to be generated locally inside the charge pump. On the other hand, a very large interpoly oxide field is built up in this erase scheme, resulting in charge leakage from the program gate PG to the floating gate FG (which results in a lower boundary for the erased threshold level), and from the floating gate FG to the control gate CG (which results in a parasitic erase path), both parasitics indicated by the arrows in Fig. 1.

These and other considerations result in a very hard boundary condition for scaling down of Flash memory devices to subhalfmicrometer dimensions, especially for embedded applications.

This problem is solved in the method of erasing at least one nonvolatile memory cell according to claim 1.

Since a negative voltage of approximately -7V is applied to both the program gate and the control gate substantially simultaneously, a high electric field across the tunnel oxide of the memory cell is created. Since the control gate to floating gate (CG-to-FG) coupling ratio is now 'aiding' the build-up of a sufficient oxide field for tunneling of electrons towards the drain junction, the required negative voltage can be reduced from the previous value of -12V down to the more relaxed value of only-7V without sacrificing erase speed. In other words, a tunneling current of electrons is caused to flow from said floating gate towards said drain region of said cell while achieving erasure of said cell.

This low-voltage erase scheme allows to reduce the internally generated negative erase voltage which enhances reliability margins and which further decreases the development entry cost for implementing the HIMOS® concept in an existing CMOS baseline process.

Moreover, due to the smaller erase voltage and due to the distribution of this voltage across the entire device structure, the electric field in the interpoly dielectric is largely relaxed with respect to the method according to the prior art. Therefore, the necessary reliability margins are much easier to accomplish than in the case of the method according to the prior art.

The present invention allows for low-voltage operation on-chip and furthermore reduces the additional cost of incorporating the resulting Flash array in a CMOS (Complementary Metal-Oxide-Semiconductor) process flow. The latter is particularly important for so-called embedded memory applications where the Flash process modules have to be economically reconciled with an already existing CMOS baseline process for fabricating chips that contain large amounts of digital or analog functions as well as Flash memory, such as e.g. smart cards.

The invention also provides a method of erasing an array or part of an array of nonvolatile memory cells. A negative voltage in the order of -7 Volt is applied simultaneously to one or more program lines and to one or more wordlines. This couples a negative voltage to the floating gates of the cells connected to these wordlines and program lines. The method of erasure utilizes a tunneling current of electrons from the floating gates of the cells towards the substrate of the cells, without the need for high negative voltages.

Additionally, a voltage at least as high as the supply voltage applied to the substrate and / or the drain regions of the cells causes a tunneling current of electrons to flow from the floating gates of the cells towards the substrate and / or the drain regions of the cells to achieve simultaneous erasure of the memory cells. Of course, the negative voltage applied to the program lines/ wordlines can be, and preferably is, generated on chip.

The described objects, as well as other objects, features, and advantages of the present invention, are apparent in the following detailed description, with reference to the annexed drawings.

Fig. 1 shows the previously used erase scheme with grounded control gate.

Fig. 2 shows the erase characteristics associated with the scheme of Fig. 1.

Fig. 3 shows the improved low-voltage erase scheme of the invention with a negative bias applied simultaneously to both gates (control gate and program gate).

Fig. 4 shows the erase characteristics associated with the scheme of Fig. 3.

Fig. 5 shows the erase time as a function of the negative gate voltage as extracted from Fig. 4 for a low (erased) threshold voltage of -4V.

Fig. 6 shows the equivalent circuit for the low voltage erase scheme.

Fig. 7 shows the erase transient characteristics according to the low-voltage erase scheme for different program-gate-to-floating-gate coupling ratio's p.

Fig. 8 shows two alternative embodiments of the low voltage erase scheme with an exemplary voltage of 5V applied to the substrate or p-well of the memory array.

Fig. 9 shows an optimized HIMOS cell layout as used in a contactless Virtual Ground Array (VGA) with shared program gates. The floating gates are formed in the first polysilicon layer, while the control gate and the program gate are formed in the second polysilicon layer. Each program gate serves as a coupling capacitor for two different cells. Duplicating the presented layout in the horizontal direction constitutes a program line which connects all program gates of two adjacent rows of cells.

Fig. 10 shows an Optimized HIMOS cell layout as used in a contactless VGA with shared program gates and shared control gates. In this case, also the control gates of adjacent cells are shared. Duplicating the presented layout in the horizontal direction constitutes a wordline which connects all control gates of two adjacent rows of cells.

Fig. 11 shows an Optimized HIMOS cell layout as used in a contactless common source array. In this case, each column of cells has a separate bitline.

Fig. 12 shows a basic virtual ground array with a shared program line.

Fig. 13 shows a virtual ground array with shared program gates. The diffusion lines are buried under the field oxide in order to save cell area (the field oxide area is complementary to the active area shown in the figure) .

Fig. 14 shows a virtual ground array with alternating source/drain configuration.

Fig. 15 shows an array layout in the case of alternating source/drain configuration.

Fig. 16 shows a virtual ground array with shared program lines and shared wordlines.

Fig. 17 shows a contactless NOR array with typical voltages to be applied during programming. The cell being programmed and two adjacent columns are shown. Dedicated source and bitlines are shared between adjacent columns.

Fig. 18 shows a contactless common source array where the bitlines of the respective columns in the array are entirely isolated. In this case, each column has its own separated bitline while the source lines can be shared and physically connected to ground (common source).

Exemplary devices have been fabricated in a 0.7 $\mu$m nonvolatile technology embedded in a CMOS technology. These devices have a thin oxide (7-9 nm) under the floating gate. The interpoly dielectric is a polyoxide of thickness 25-30 nm, and the oxide between the control gate and the channel region is 15 nm. The length of the floating gate is 0.7 $\mu$m, the length of the control gate is 1.0 $\mu$m, and the overall cell size is 13-15 $\mu$m$^2$.

The method as disclosed in the present application can also be applied to a 1.25 $\mu$m nonvolatile technology embedded in a CMOS technology or in a 0.5 $\mu$m nonvolatile technology embedded in a CMOS technology or in a 0.35 $\mu$m or smaller length nonvolatile technology embedded in a CMOS technology.

The term "supply voltage" of a chip including nonvolatile memory cells is defined as the external voltage by which power is added to the chip or the electronic system in which the chip is incorporated. By preference the supply voltage of a chip including nonvolatile memory cells is the supply voltage of the CMOS technology in which the nonvolatile memory technology is incorporated. The supply voltage of a CMOS technology is the maximum allowed voltage on gate and drain for the minimum allowed gate length in that technology. For the nonvolatile memory 0.7 $\mu$m technology as disclosed in EP-A-0501941, the supply voltage of the nonvolatile memory technology is 5 Volt. Any external voltage other than the supply voltage is defined as an external voltage.

A voltage that is generated on-chip is meant to be generated by charge pumps incorporated on said chip and is negative or higher than the supply voltage. Such an on-chip generated voltage is not able to deliver a high power.

The present invention relates to a novel erase scheme that allows to considerably reduce the negative gate bias necessary for Flash erase. Especially for embedded memory applications where the minimisation of the impact of the memory technology on the surrounding CMOS circuits is a prime issue, the reduction of the negative erase voltage is of major importance. Furthermore, a voltage reduction also simplifies the design of the high voltage generating and switching circuitry, and increases reliability margins for the entire process.

Fig. 1 shows a schematic of the previously used negative-gate-bias erase scheme where the CG is grounded and the negative voltage is applied only to the PG for inducing a high oxide field between the FG and the drain junction.

In this case, the voltage across the tunnel oxide between the FG and the drain is approximately given by the following equation:

$$\left|V_{fg} - V_d\right| \approx p(V_t - V_{pg}) + (1-d)V_d \qquad (1)$$

where $V_{pg}$, $V_{fg}$ and $V_d$ are the program gate voltage (PG voltage), the floating gate voltage (FG voltage) and the drain voltage during erasure, respectively, $V_t$ is the threshold voltage of the memory cell measured from the program gate (PG), and p and d are the program gate to floating gate (PG-to-FG) and the drain-to-FG capacitive coupling ratio's, respectively. Taking typical values for the parameters into account (p~=50 %, d~=10 %, $V_d$~=5V, $V_t$ varies between 2V and -4V) it can be calculated that, in order to obtain a reasonable erase time in the order of milliseconds, a program gate PG voltage of -12V is typically required for a state-of-the-art tunnel oxide of 8nm. In order to generate this high negative voltage on-chip and to switch it onto the program gate PG during the Flash erase operation, an even higher voltage in the order of -16V has to be generated locally inside the charge pump. On the other hand, a very large interpoly oxide field is built up in this erase scheme, resulting in charge leakage from the program gate PG to the floating gate FG (which results in a lower boundary for the erased threshold level), and from the floating gate FG to the control gate CG (which results in a parasitic erase path), both parasitics indicated by the arrows in Fig. 1.

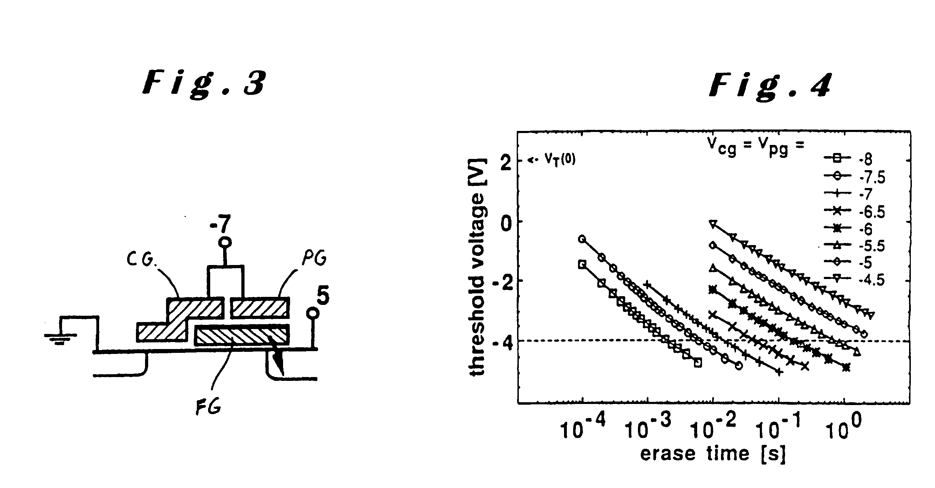

These and other considerations result in a very hard boundary condition for scaling down of Flash memory devices to subhalfmicrometer dimensions, especially for embedded applications. Therefore, a new erase scheme is suggested wherein the CG and PG of the considered wordline can be connected through an additional state-of-the-art switch in the row decoder, which is only operated in the erase mode. Then, a negative voltage of approximately -7V is applied to both gates simultaneously, in order to create a high electric field across the tunnel oxide of the memory cell. This is shown schematically in Fig. 3. Since the CG-to-FG coupling ratio is now aiding the build-up of a sufficient oxide field for tunneling of electrons towards the drain junction, the required negative voltage can be reduced from the previous value of -12V down to the more relaxed value of only -7V without sacrificing erase speed. Indeed, in this case, the voltage across the tunnel oxide is given by:

$$\left|V_{fg} - V_d\right| \approx p(V_t - V_g) + (1-d)V_d - cV_g \qquad (2)$$

where c is the CG-to-FG coupling ratio (typically 20 %) and $V_g$ represents the (common) gate voltage applied to both gates. As compared to Eq. (1) it is clear that the additional term $cV_g$ increases the oxide field independently of the value of the threshold voltage of the cell. The corresponding erase characteristics are shown in Fig. 4. Moreover, due to the smaller erase voltage and due to the distribution of this voltage across the entire device structure, the electric field in the interpoly dielectric is largely relaxed with respect to the previous scheme of Fig. 1. Therefore, the necessary reliability margins are much easier to accomplish than in the case of Fig. 1.

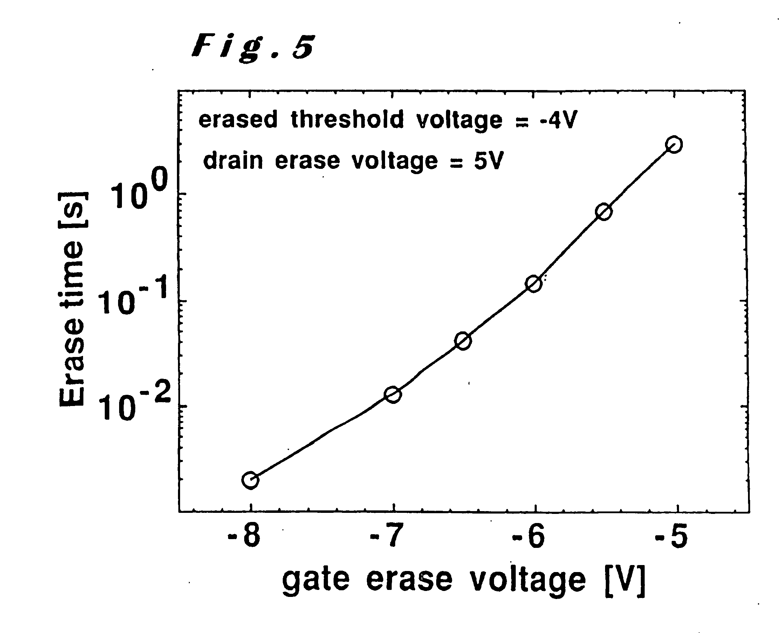

Fig. 5 shows the erase time extracted from Fig. 4 as a function of the (negative) erase voltage. It is demonstrated that a coli such as the one presented in Fig. 3 can be erased to a threshold voltage of -4V in only 10ms using only -7V at the gate. If erase speed is not an issue, as in e.g. EPROM replacement applications, the erase voltage can even be allowed to decrease further to -5V.

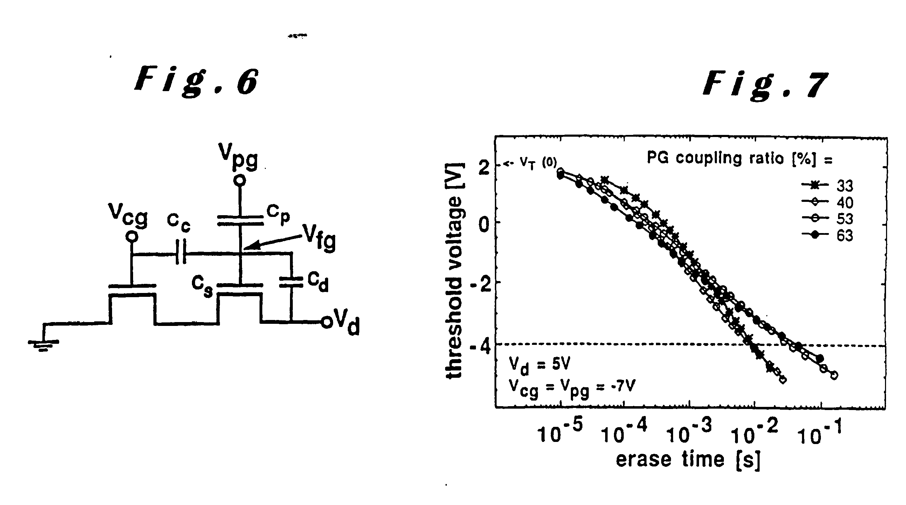

Fig. 7 shows the transient erase characteristics for a gate voltage of -7V and for a number of memory cells that differ only according to the coupling capacitor $C_p$ between the PG and the FG.

Fig. 6 shows the cell's equivalent circuit, represented by two transistor channels in series and three coupling capacitors $C_d$, $C_p$ and $C_c$ between the FG and the drain, PG and CG. It is demonstrated that for this particular case, the erase speed increases with decreasing coupling capacitor, and hence with decreasing cell area. This can be explained from Eq. (2) : at the beginning of the erase operation, the threshold voltage of the cell is typically 2V which reduces Eq.(2) to:

$$\left|V_{fg} - V_d\right| \approx 9p + (1-d)V_d + 7c \qquad (3)$$

for an erase voltage of -7V. Since p has a larger coefficient than c, the cells with a larger coupling capacitor exhibit a faster erase speed at the beginning of the erase operation (larger initial slope in Fig. 7). At the end of the erase operation, Eq.(2) becomes:

$$\left| V_{fg} - V_d \right| \approx 3p + (1-d)V_d + 7c \qquad\qquad (4)$$

At that point in time, the impact of the c-term is already more than twice as large as that of the p-term, which explains the faster erase speed at lower (more negative) threshold voltages (final slope in Fig. 7). Physically, it means that the smaller cells require a less positive FG charge for the same externally measured threshold voltage, which corresponds to a higher oxide field, and hence a faster erase speed.

This is a remarkable property since the smaller the cell, the faster it erases, in contrast to all other erase schemes known in the prior art. It makes device design much easier since the optimum coupling ratio for programming is never compromised by erase speed requirements. Also, this erase scheme is clearly interesting for scaled-down Flash memories.

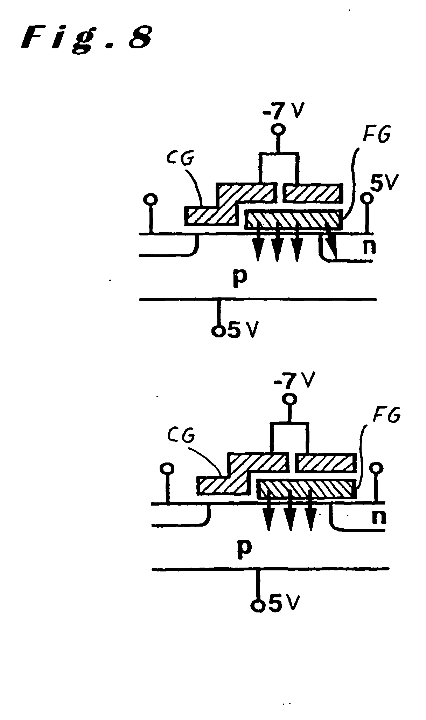

Another embodiment of this new erase scheme is shown in Fig. 8. In this case, the positive voltage is not only applied to the drain, but also to the substrate (or p-well) of the memory array. In this case, a high oxide field is established over the entire FG channel region, and the tunneling current and its resulting oxide degradation become more uniformly spread over a wider oxide area. In this erase scheme, which is still requiring only a low voltage in the order of -7V, not only oxide degradation is relaxed with respect to the cases of Figs. 1 and 3, but also power consumption during the erase operation is greatly reduced. Indeed, it is well-known in the state-of-the-art that the schemes presented in Figs. 1 and 3 suffer from a relatively high band-to-band tunneling (BBT) current from the drain towards the substrate or p-well. This BBT current is typically several 100's of nA's per cell, which implies a current consumption in the order of tens of mA's for a 64 kbit array or sector. The alternative scheme of Fig. 8 avoids this problem by shortcircuiting drain and well. As a result, only the very small tunneling current (nA-level and below) has to be delivered which also results in a low-power erase scheme.

Another embodiment of the new erase scheme is obtained when the positive voltage is only applied to the substrate (or p-well) and not to the drain junction of the cell, which is left floating, as depicted in the lower portion of Fig. 8.

As one of ordinary skill in the art can recognise, the foregoing methods can be executed on the memory cell array configurations as detailed hereafter or on other flash memory cells or array configurations.

Several illustrative array embodiments are described below, which use similar cell layouts and the same basic cell operating modes. Depending on the particular array configuration, different features are however obtained from the point of view of array operation. Therefore, the basic cell layouts are first discussed and thereafter, different array configurations and their typical features are presented.

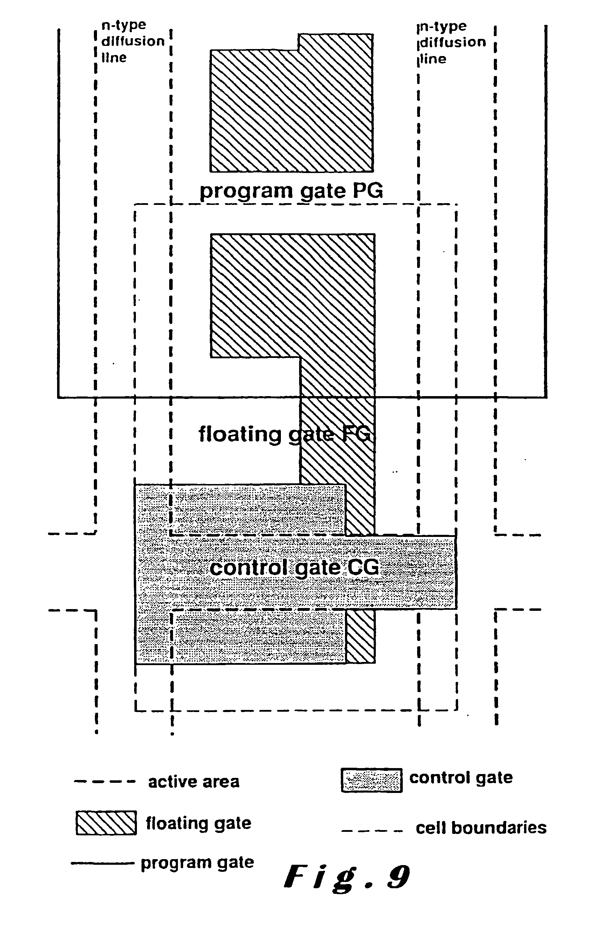

Figure 9 shows a HIMOS cell layout as used in a contactless array with shared program gates. The shape of the wordline has been designed in order to minimize the parasitic coupling coefficient between the control gate and the floating gate. On the other hand, the program gates of two adjacent wordlines are merged into one program line, which is also running horizontally across the array.

Since the source and drain junctions of the different cells are connected to vertical diffusion lines which run under the polysilicon wordlines and program lines, these diffusion lines are connected to a metal strap (for example, every 16 or 32 bits). This explains the term "contactless array".

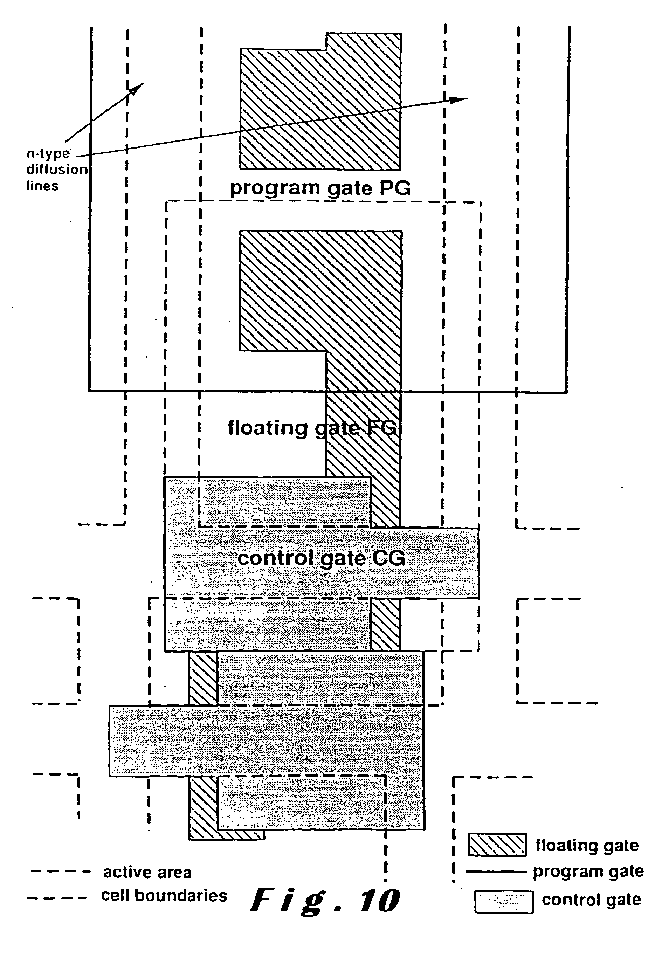

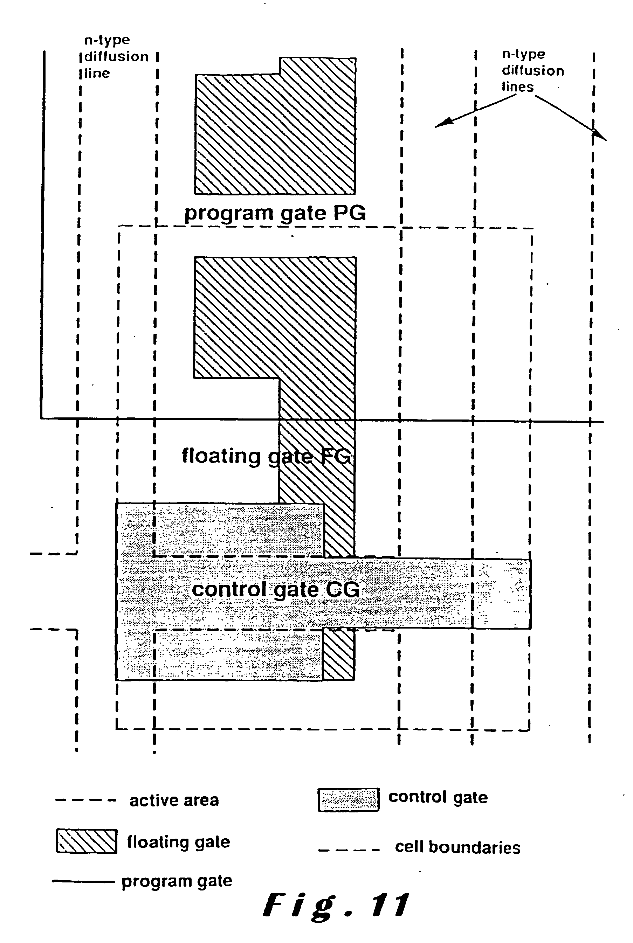

Fig. 10 shows a HIMOS cell layout as used in a contactless VGA with shared program gates and shared control gates. Fig. 11 shows a HIMOS cell layout as used in a contactless common source array.

Erasure can be accomplished in different ways:

- Fowler-Nordheim tunneling of electrons from the floating gate towards the drain junction is activated by applying a high negative voltage (-10 to -12V) to the program gate, while the supply voltage is applied to the drain. In this erase mode, the control gate has to be kept grounded in order to maximize the tunneling field at the drain-to-floating-gate overlap. The potential applied to the source junction is of no importance during erasure.
- If the wordline and the program line of the considered sector are connected during the erase operation, a lower gate voltage can suffice (typically -7 to -8V). The parasitic control-gate-to-floating-gate capacitance is then used to further enhance the electric field across the tunnel oxide. In this case, the erase mechanism stays essentially the same as in the previous case, but the necessary negative voltage is lowered at the expense of additional switching circuitry.
- Another possible erase scheme is offered by the channel erase mechanism. In this case, a negative voltage is applied to the program line, eventually combined with the supply voltage applied to the substrate (or p-well) of the memory array. In this case, a uniform erase current is obtained in the tunnel oxide region which is beneficial from the point of view of oxide stress and programming window closure after write/erase cycling. The main advantage of this scheme is the absence of any band-to-band tunneling current from the drain junction to the p-type substrate or well. The main disadvantage is the higher negative voltage which is required if only a program gate voltage is applied, and the higher processing complexity (triple well CMOS) if the supply voltage is simultaneously applied to the substrate or well.

- A last possible erase mechanism is the polyoxide conduction from floating gate to control gate which can be established by applying a high positive voltage to the control gate. This is possible without any changes to the cell design because the coupling coefficient between the control gate and the floating gate has already been minimized, as mentioned before. The main advantages are the redundancy of a negative charge pump and the corresponding negative voltage switching circuitry, the lower power consumption, less critical disturb effects, and the redundancy of a tunnel oxidation step. The main disadvantages are the additional processing complexity related to the formation of a textured polyoxide layer, and the lower number of write/erase cycles.

In general, the above-mentioned erase mechanisms do not influence the cell layout, except for the polyoxide alternative, which does not need a tunnel oxide mask.

The read-out operation requires a small voltage at the drain junction (typically 2V) and a small voltage at the control gate (typically 3V) while the program gate is kept grounded. Depending on the particular array organisation, it may, however, be necessary to apply a positive or negative voltage to the program gate during the read-out operation, as explained below. The considered operating modes are summarised in Table 1.

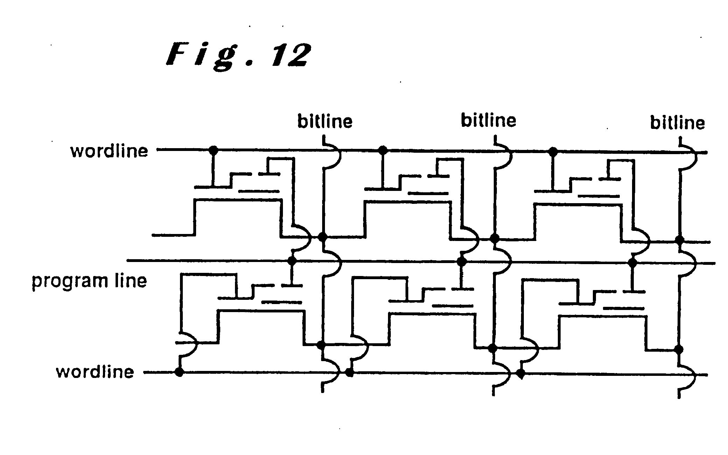

A typical example of a contactless array is the virtual ground array. The practical application of the virtual ground concept to HIMOS cells is shown in Figure 12. Due to the sharing of the program line between two adjacent rows, the cells are mirrored along the two horizontal symmetry axes in order to produce the array. Along every row the cells are oriented in the same direction (source on the left, drain on the right hand side) and, therefore, every diffusion line is connected to the source junction of the cell on the right hand side, as well as to the drain junction of the cell on the left hand side of the considered diffusion line.

This configuration has several consequences:

- Since every diffusion line serves the function of a source line (connected to the source junctions of cells) as well as that of a bitline (connected to the drain junctions of cells), source lines and bitlines are indistinguishable and none of these lines can be physically connected to the substrate (or ground) potential. This "virtual ground property" implies that all diffusion lines have to be connected to the column decoder which has a small but negative impact on readout speed in a memory circuit;
- Due to the sharing of the diffusion lines between neighboring cells a very compact array is obtained which allows relatively high density integration. The cell area for a 0.7 $\mu$m technology is in the order of 13 to 15 $\mu$m$^2$ depending on the available interpolysilicon technology;
- Unintentional reverse programming of the cell which is next to the cell being programmed has to be suppressed sufficiently. This offers no problem in HIMOS arrays because of the highly asymmetrical transistor structure;
- Column decoding is not straightforward since neighboring cells in the same row can not be read-out at the same time, due to the shared diffusion lines. This problem is solved in the peripheral electronics which control the access to the array;
- The smallest erase sector that can be defined in the case of Fowler-Nordheim tunneling is a pair of adjacent rows sharing the same program line. All diffusion lines in the considered sector are connected to the supply voltage during erasure;
- In the case of polyoxide erase, the smallest sector is defined as a wordline, since the erase voltage is then applied to the control gate.

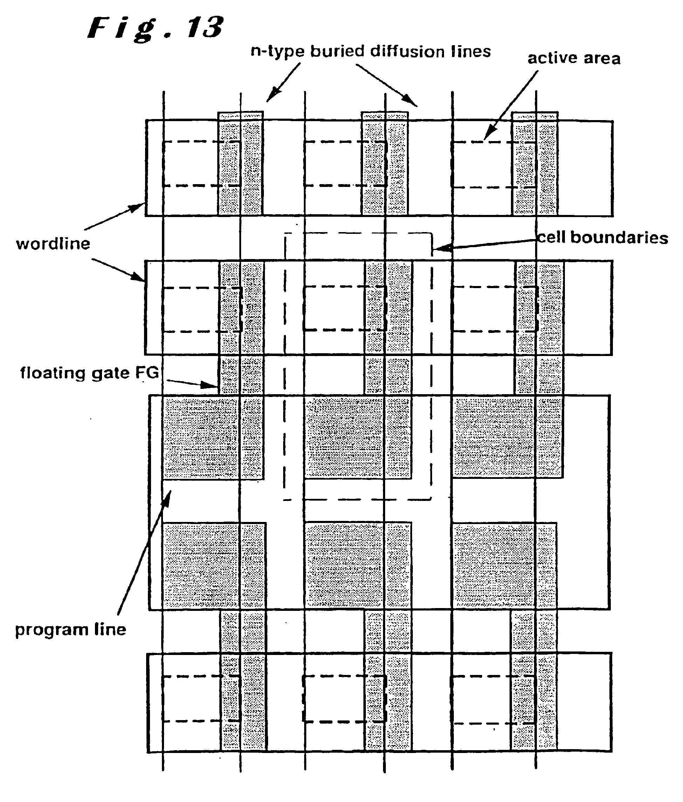

When the source and drain junctions are formed before the growth of the field oxide, the spacing between adjacent floating gates in a row is reduced to the minimum polysilicon spacing rule, which realizes a very compact array. This embodiment of the cell is also described in EP-A-0501941. Fig. 13 shows the resulting layout when implementing this cell in a contactless array. This cell has an area of 10 $\mu$m$^2$ in a 0.7 $\mu$m technology.

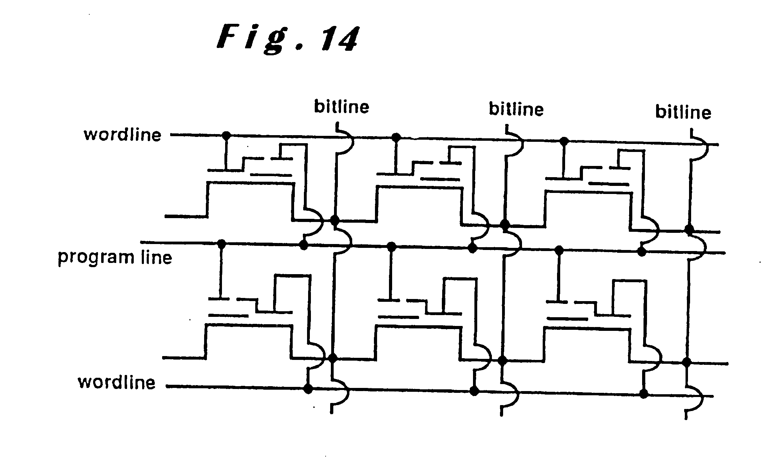

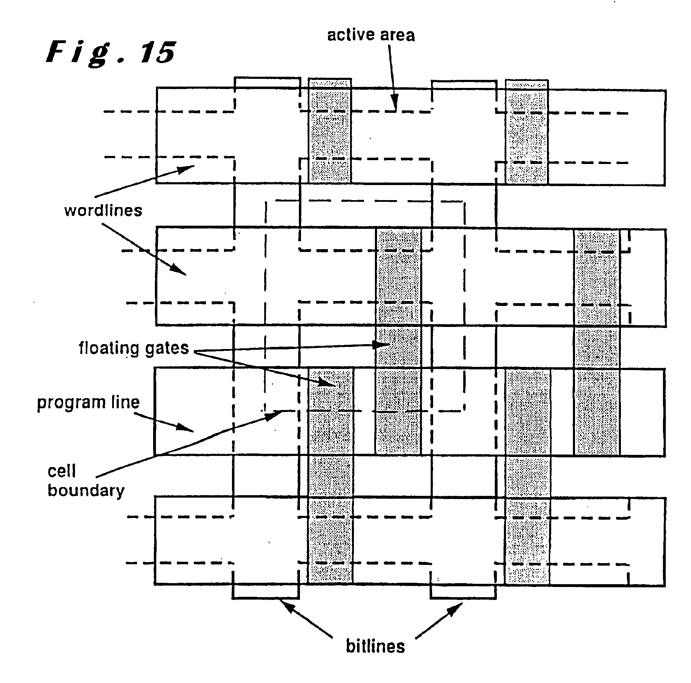

A second embodiment of a virtual ground HIMOS array is shown in Fig. 14. In this case, all cells on a particular row are oriented in the same direction but the horizontal orientation of the cells is alternating between adjacent rows. Since the source and drain junctions of the cells switch places between rows, the L-shape of the floating gate can be replaced by rectangular floating gates in order to save area (Fig. 15). The floating gates are formed in the first polysilicon layer, while the control gate and the program gate are formed in the second polysilicon layer. Each program gate serves as a coupling capacitor for two different cells. Duplicating the presented layout in the horizontal direction constitutes a program line which connects all program gates of two adjacent rows of cells. The interconnected control gates form the wordline of the array which is running horizontally over the active transistor area and over the source and drain junctions of the cells sharing the same row. Since the source and drain junctions of the different cells are connected to vertical diffusion lines which run under the polysilicon wordlines and program lines, these diffusion lines are connected to a metal strap, for example, every 16 of 32 bits. This explains the term "contactless array". Depending on the particular array configuration, the symmetry axes of the array can be positioned in a number of orientations. This is especially interesting in high density applications.

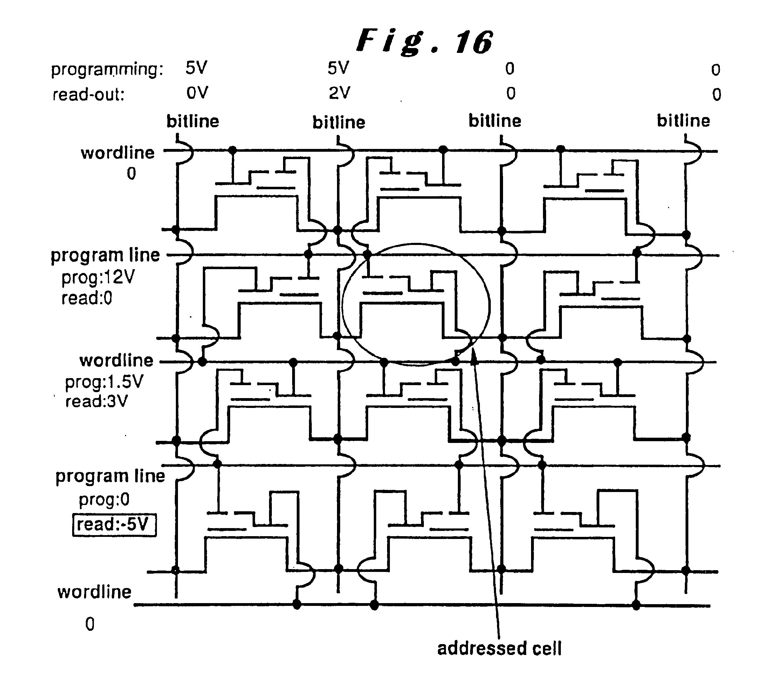

Fig. 16 shows a third embodiment of a virtual ground HIMOS array. The wordlines are shared between two adjacent rows in the array in order to further decrease the cell area. This is possible due to the triple gate structure of the transistor; although two rows of cells are now selected through the same wordline, programming selectivity is still maintained since the considered rows do not share the same program line. In order to obtain programming selectivity on a row of cells, the supply voltage has to be applied to the source junction of the cell that shares its drain junction with the cell being programmed as shown in the figure. The resulting gain in cell area is due to the removal of the spacing rule for the polysilicon wordlines from the cell dimensions as shown in Fig. 10. However, during the read-out operation the program line is grounded and, therefore, read-out selectivity is lost, if the known read-out scheme is maintained. This problem can be resolved by applying a negative (deselect) voltage to the program line which is coupled to the row that is unintentionally selected. Consequently, the cells on this deselected row do not draw any current during the read-out operation. This solution maintains the cell performance from the point of view of programming speed, read-out current and drain disturb immunity, at the expense of additional complexity in the row decoder circuitry. If negative voltages are already used for the erase operation, this overhead can, however, be strongly reduced.

Otherwise, the threshold-voltage window can also be defined between two distinct positive values (e.g. +2V and +6V), and a read-out voltage of 4V is then applied to the program line of the selected row. This more traditional read-out scheme allows the different rows to be addressed separately without the need for negative deselect voltages, however, at the expense of a lower cell performance with respect to programming speed and cycling endurance.

However, if a negative deselect voltage is applied, a novel soft-erase effect might occur in the case of Fig. 16. While reading the indicated cell, a negative voltage of -5V is applied to the program line of the row that shares its wordline with the cell being read. If any cell on this particular program line would be subject to the drain read-out voltage of 2V as well, a soft-erase situation would occur. Indeed, the presence of the deselect voltage together with the drain readout voltage would further increase the electric field in the tunnel oxide, thereby causing a small amount of charge being transferred across the tunnel oxide during each read-out cycle on the cell above. In order to minimize this charge leakage, the following conditions have to be fulfilled:

a. The cells on a particular wordline should have alternating orientations.
b. The cells that share a common wordline should be arranged in such a way that each pair of these cells connected to the same bitline have the opposite orientation along this wordline.
c. The cells that share a common program line should be arranged in such a way that each pair of these cells connected to the same bitline have the same orientation along this program line.

For this "disturb- immune" array organization, the deselect voltage is never present simultaneously with the drain read-out voltage. Under these circumstances, more than 10 years soft-erase lifetime can be guaranteed without any problem ever for tunnel oxides of only 8nm. The resulting minimum cell area is 11 $\mu m^2$ in a 0.7 $\mu m$ technology.

For completeness, it should be mentioned that the wordline-oriented sector erase operation in the case of polyoxide conduction implies that the smallest sector is in this case formed by a pair of wordlines.

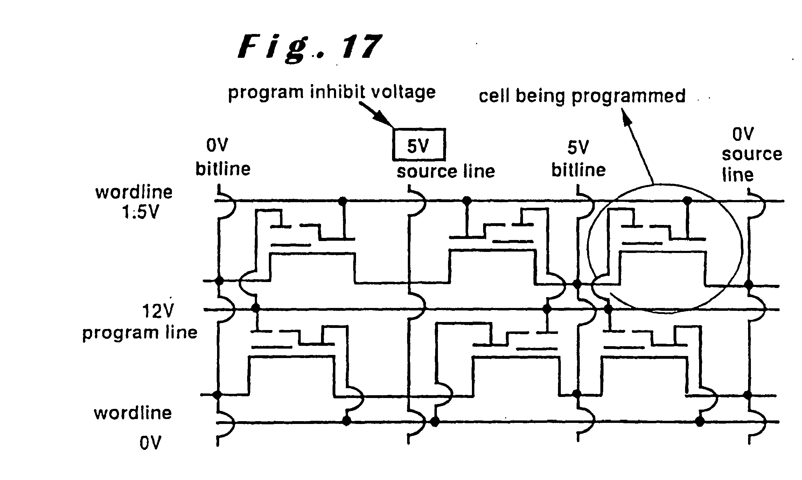

Another embodiment of a contactless array for the HIMOS cell is given in Fig. 17. In this case, every diffusion line is either a dedicated bitline or a dedicated source line. This configuration is very similar to the conventional NOR configuration, but the diffusion lines are now shared between cells in a row in contrast with the conventional NOR scheme where sharing is established between cells in the same column.

A problem with this array is the fact that additional voltages are necessary in order to obtain selectivity during programming. Indeed, the cell that shares the bitline of the cell being programmed on the same row will also be programmed unless the supply voltage is also applied to its source junction (Fig. 17). If this correction is included the problem is resolved since the next cell on the same row is biased in the reverse way, which suppresses the enhanced hot-electron injection mechanism. A consequence of this configuration is, again, that adjacent cells in the same row cannot be programmed or read-out at the same time. The byte organization thus has to be adapted by a proper decoding scheme.

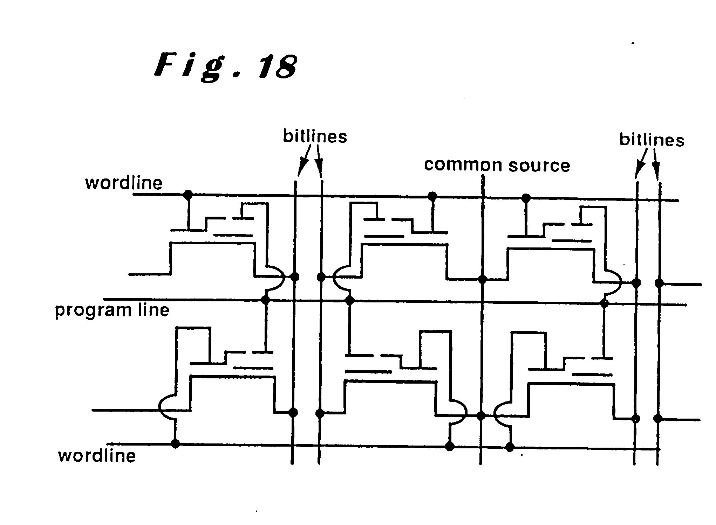

Fig. 18 shows a contactless common source array, where the bitlines of the respective columns in the array are entirely isolated from each other. The main advantage of this configuration is the fact that the source lines can be grounded through a substrate (or well) contact, e.g. every 16 or 32 bits. In that case, the source potential always stays very close to the ground potential which ensures a high read-out speed, even in large memory arrays. Another advantage is the straightforward decoder design: the control gate forms the wordline, each column of cells connects to a separate bitline, and source decoding becomes redundant. The main disadvantage is the larger cell area (typically 20-25 $\mu m2$ in a 0.7 $\mu m$ CMOS technology) which is due to the bitline isolation.

Preferred embodiments of the present invention have been described herein. It is to be understood, however, that changes and modifications can be made without departing from the true scope and spirit of the present invention. The true scope and spirit of the present invention are defined by the following claims, to be interpreted in light of the foregoing specification.

Table 1 : Typical operating voltages for the HIMOS cell in the write mode, the different erase modes and the read-out mode.

| | Source | Drain | Control gate | Program gate | Substrate or p-well |
|---|---|---|---|---|---|
| Write | 0 | 3.3/5 | 1/1.5 | 12 | 0 |
| Tunnel erase | - | 3:3/5 | 0 | -12 | 0 |
| Tunnel erase (alternative) | - | 3.3/5 | -7 | -7 | 0 |
| Channel erase | 3.3/5 | 3.3/5 | 0 | -12 | 3.3/5 |
| Channel erase (alternative) | 3.3/5 | 3.3/5 | -7 | -7 | 3.3/5 |
| Polyoxide erase | - | 0 | 12 | 0 | 0 |
| Read-out | 0 | 2 | 3 | $\geq 0$ | 0 |

**Claims**

1. A method of erasing at least one nonvolatile memory cell, said cell comprising :

   - a semiconductor substrate including a source and a drain region and a channel therebetween,
   - a floating gate (FG) erextending over a portion of the drain region with a dielectric layer therebetween and extending over a portion of said channel, further referred to as the floating gate channel,
   - a control gate (CG) extending over another portion of the channel region, further referred to as the control-gate channel and capacitively coupled to the floating gate (FG), and
   - a program gate (PG) capacitively coupled through a further dielectric layer to said floating gate,

   said method comprising the steps of:

   - applying a first negative voltage to said program gate (PG) and substantially simultaneously to said control gate thereby coupling a negative voltage to said floating gate (FG) of said cell; and
   - applying a second voltage to at least one of said drain region and said substrate of said cell,

   **characterised in that**
   said first negative voltage is in the order of -7V and said second voltage is a positive voltage.

2. The method according to claim 1 wherein said first negative voltage is in the range of -5V to -8V.

3. The method as recited in claim 1 wherein said dielectric layer is a thin oxide layer.

4. The method according to any one of the preceding claims, wherein said second voltage is equal to or higher than the supply voltage.

5. The method according to any one of the preceding claims, wherein said second voltage is applied to both said substrate and said drain region.

6. The method according to any one of the preceding claims, wherein the first negative voltage is an on-chip generated voltage.

7. The method according to any one of the preceding claims, wherein the second voltage is an on chip generated voltage higher than the supply voltage.

8. The method according to any one of the preceding claims, wherein an array or part of an array of nonvolatile memory cells is erased, said array or part of an array comprising a number of rows of said cells.

9. The method according to claim 8, wherein said control gates of said cells on the same row are connected to a common word-line, and said program gates of said cells are connected to a common program line, said first negative voltage being applied to at least one of said program lines and to at least one of said wordlines.

**Patentansprüche**

1. Verfahren zum Löschen von wenigstens einer nichtflüchtigen Speicherzelle, wobei diese Zelle umfasst:

   - ein Halbleitersubstrat, das eine Sourcezone und eine Drainzone und einen dazwischenliegenden Kanal einschließt,
   - ein Floatinggate (FG) bzw. schwebendes Gate, das über einen Abschnitt der Drainzone mit einer dazwischenliegenden dielektrischen Schicht und über einen Abschnitt des Kanals, der hier Floatinggate-Kanal genannt wird, verläuft,
   - ein Controlgate (CG) bzw. Steuergate über einem anderen Abschnitt der Kanalzone, der hier Controlgate-Kanal genannt wird, und kapazitiv an das Floatinggate (GF) gekoppelt ist,
   - ein Programmgate (PG), das kapazitiv über eine weitere dielektrische Schicht an das Floatinggate gekoppelt ist, wobei das Verfahren folgende Schritte umfasst:
   - Aufbringen einer ersten negativen Spannung auf dem Programmgate (PG) und im Wesentlichen gleichzeitig auf dem Steuergate, wobei eine negative Spannung an das Floating-gate (FG) der Speicherzelle gekoppelt wird, und
   - Aufbringen einer zweiten Spannung auf wenigstens einer Drainzone und dem Substrat der Zelle,

   **dadurch gekennzeichnet, dass**
   die erste negative Spannung im Bereich von -7 V liegt und
   die zweite Spannung eine positive Spannung ist.

2. Verfahren nach Anspruch 1, wobei die erste negative Spannung im Bereich von -5 V bis -8 V liegt.

3. Verfahren nach Anspruch 1, wobei die dielektrische Schicht eine dünne Oxydschicht ist.

4. Verfahren nach einem der vorstehenden Ansprüche, wobei die zweite Spannung gleich der Versorgungsspanunng oder höher ist.

5. Verfahren nach einem der vorstehenden Ansprüche, wobei die zweite Spannung sowohl auf dem Substrat als auch auf der Drainzone aufgebracht ist.

6. Verfahren nach einem der vorstehenden Ansprüche, wobei die erste Spannung eine auf dem Chip erzeugte Spannung ist.

7. Verfahren nach einem der vorstehenden Ansprüche, wobei die zweite Spannung eine auf dem Chip erzeugte Spannung ist, welche die Versorgungsspannung überschreitet.

8. Verfahren nach einem der vorstehenden Ansprüche, bei welchem ein Feld oder Teil eines Felds nichtflüchtiger Speicherzellen gelöscht wird, wobei das Feld oder der Teil eines Felds eine Reihenzahl der Zellen umfasst.

9. Verfahren nach Anspruch 8, bei welchem die Steuergates der Zellen auf derselben Reihe mit einer gemeinsamen Wortzeile verbunden sind und die Programmgates der Zellen mit einer gemeinsamen Programmzeile verbunden sind, wobei die zweite Spannung wenigstens auf einer Programmzeile und wenigstens auf einer Wortzeile aufgebracht wird.

**Revendications**

1. Procédé d'effacement d'au moins une cellule de mémoire non volatile, ladite cellule comprenant :

   - un substrat semi-conducteur comprenant une région source et une région drain et un canal entre elles,
   - une grille flottante (FG) s'étendant sur une partie de la région drain avec une couche diélectrique entre elles et s'étendant sur une partie dudit canal, dénommé ci-après canal de la grille flottante,
   - une grille de contrôle (CG) s'étendant sur une autre partie de la région du canal, dénommé ci-après canal de la grille de contrôle et couplé de manière capacitive à la grille flottante (FG), et
- une grille de programme (PG) couplée de manière capacitive par une autre couche diélectrique à ladite grille flottante,

ledit procédé comprenant les étapes consistant :

- à appliquer une première tension négative à ladite grille de programme (PG) et de manière pratiquement simultanée à ladite grille de contrôle, couplant ainsi une tension négative à ladite grille flottante (FG) de ladite cellule, et
- à appliquer une deuxième tension à au moins un de ladite région drain et dudit substrat de ladite cellule,

**caractérisé en ce que**
ladite première tension négative est de l'ordre de -7V et ladite deuxième tension est une tension positive.

2. Procédé selon la revendication 1, dans lequel ladite première tension négative est de l'ordre de -5V à -8V.

3. Procédé selon la revendication 1, dans lequel ladite couche diélectrique est une mince couche d'oxyde.

4. Procédé selon une quelconque des revendications précédentes, dans lequel ladite deuxième tension est égale ou supérieure à la tension d'alimentation.

5. Procédé selon une quelconque des revendications précédentes, dans lequel ladite deuxième tension est appliquée audit substrat et à ladite région drain.

6. Procédé selon une quelconque des revendications précédentes, dans lequel ladite première tension négative est une tension générée sur la puce.

7. Procédé selon une quelconque des revendications précédentes, dans lequel ladite deuxième tension est une tension générée sur la puce qui est supérieure à la tension d'alimentation.

8. Procédé selon une quelconque des revendications précédentes, dans lequel une matrice ou partie d'une matrice de cellules de mémoire non volatile est effacée, ladite matrice ou partie d'une matrice comprenant un certain nombre de rangées desdites cellules.

9. Procédé selon la revendication 8, dans lequel lesdites grilles de contrôle desdites cellules sur la même rangée sont connectées à une ligne de mot commune, et lesdites grilles de programme desdites cellules sont connectées à une ligne de programme commune, ladite première tension négative étant appliquée à au moins une desdites lignes de programme et à au moins une desdites lignes de mot.

# Fig.1

PRIOR ART

# Fig.2

PRIOR ART

Fig.4

Fig.3

# Fig. 5

erased threshold voltage = -4V

drain erase voltage = 5V

Erase time [s] (vertical axis, values: $10^0$, $10^{-1}$, $10^{-2}$)

gate erase voltage [V] (horizontal axis, values: -8, -7, -6, -5)

# Fig. 6

# Fig. 7

# Fig.8

n-type
diffusion
line

n-type
diffusion
line

program gate PG

floating gate FG

control gate CG

- - - - active area

floating gate

program gate

control gate

- - - - cell boundaries

*Fig. 9*

n-type
diffusion
lines

program gate PG

floating gate FG

control gate CG

- - - - active area
- - - - cell boundaries

***Fig. 10***

floating gate
program gate
control gate

n-type
diffusion
line

n-type
diffusion
lines

program gate PG

floating gate FG

control gate CG

- - - - active area

control gate

floating gate

- - - - cell boundaries

program gate

*Fig. 11*

*Fig. 12*

# Fig. 13

n-type buried diffusion lines          active area

wordline

floating gate FG

program line

cell boundaries

*Fig. 14*

Fig. 15

EP 1 189 238 B1

**F i g . 16**

programming: 5V 5V
read-out: 0V 2V

bitline 0 0
bitline 0 0
bitline

wordline 0

program line
prog:12V
read:0

wordline
prog:1.5V
read:3V

program line
prog:0
read:-5V

wordline 0

addressed cell

23

# Fig. 17

program inhibit voltage

cell being programmed

0V bitline

5V

source line

5V bitline

0V source line

wordline 1.5V

12V program line

wordline 0V

*Fig. 18*

EP 1 189 238 B1